# EUROPEAN PATENT SPECIFICATION

(11) **EP 1 848 029 B1**
(45) Date of publication and mention of the grant of the patent: **11.01.2017**
(21) Application number: 06007992.8
(22) Date of filing: 18.04.2006
(51) Int. Cl.: H01L 21/60, H01L 21/58, H01L 23/538, H01L 23/498, H05K 1/18, H05K 3/30, H05K 3/46

(54) **Carrying structure of electronic components**
Trägerstruktur von elektronischen Komponenten
Structure portante de composants électroniques

(43) Date of publication of application: 24.10.2007
(73) Proprietor: Unimicron Technology Corp., Taoyuan (TW)
(72) Inventor: Hsu, Shih-Ping Phoenix Precision Technology Corp., Hsin-chu Taiwan (TW)
(74) Representative: Papula Oy

(56) References cited:
- EP-A1- 1 139 705
- US-A1- 2003 102 572
- US-A1- 2005 048 759
- US-A1- 2005 122 698
- US-A1- 2006 087 037

## Description

### FIELD OF THE INVENTION

The present invention relates to a carrying structure of electronic components, and more particularly, to a carrying structure for carrying and fixing electronic components.

### BACKGROUND OF THE INVENTION

IBM corp. introduced flip chip package technique in early 1960, the flip chip technique differs from the earlier wire bonding technique in that electrical connections between a semiconductor chip and a circuit board are established through solder bumps rather than traditional gold wires. Advantages of the flip chip technique are increased packaging density and reduced package size. Additionally, the flip chip technique requires no metal conductive wires, thus enhancing electrical properties and satisfying the needs for high-density and high-speed semiconductor devices.

In current flip chip technique, electrode pads are disposed on an active face of a semiconductor IC chip, and corresponding electrode pads are also provided on the circuit board for carrying the chip. Solder bumps or other conductive adhesives can be appropriately disposed between the chip and the circuit board, so that the active face of the chip is connected face down on the circuit board, wherein the electrical and mechanical connections between the chip and the circuit board are provided through the solder bumps or conductive adhesives.

Fig. 1 shows a Flip Chip Ball Grid Array (FCBGA) packaging structure in U.S. patent No. 6,774,498. A semiconductor chip 10 comprises an active surface, on which electrode pads 101 for signal input and output are provided. Metal bumps 11 are formed on the electrode pads 101 and electrically connected to electrical connecting pads 121 of a circuit board 12. The circuit board is formed with a plurality of wiring layer 122 and insulating layers 123; conductive structures 125 are connected between two wiring layers 122. On the uppermost wiring layer 122 of the circuit board 12 is formed with a solder mask 13 to protect the wiring layer 122 while expose the electrical connecting pads 121. Conductive structures such as solder balls 14 are formed on the electrical connecting pads 121, completing the FCBGA packaging structure. However, during the fabrication process of the FCBGA package, the circuit board 12 is separately fabricated from the process of electrically connecting the semiconductor chip 10 to the circuit board 12 for packaging. In other words, the circuit board is an independent process, while connecting the semiconductor chip 10 to the circuit board 12 is another independent process. These two processes being independently implemented results in uneven quality in production and long production cycle, and its electrical properties can only reach certain levels but cannot be further improved. Moreover, although the FCBGA structure can be utilized in high pin count and high frequency products, but the overall cost of packaging is high and the technique still faces with many limitations, especially in the electrical connections. Due to environmental concerns, conventionally used soldering materials for electrical connections, such as lead (Pb), are banned, and instead alternative materials with less desirable electrical, mechanical and physical properties are used.

Additionally, during the fabrication of flip chip semiconductor device, after a wafer IC fabrication step, an Under Bump Metallurgy (UBM) structure layer is formed on the electrode pads of the chips in the wafer for carrying metal bumps, then a singulation process is performed to segment the wafer into a plurality of single chips, then each semiconductor chip is electrically connected to a circuit board, wherein the fabrication processes for the UBM structure layer and the metal bumps are very expensive and complex.

Thus, for a flip chip semiconductor device that requires corresponding electrical connecting units (e.g. metal bumps and pre-soldering bumps) to be respectively formed on the semiconductor chip and the corresponding circuit board, it not only increases the number of fabrication steps and cost, but also reduces the reliability of the fabrication.

Moreover, the aforementioned semiconductor packaging structure is directly adhere to the topmost area of the circuit board and encapsulated with gel, and the bottom surface of the circuit board is mounted with solder bumps. Such a vertical stacking structure increases the overall height. In addition, when the semiconductor chip is sealed with the gel, it can no longer make other connections, such as for chip stacking or circuit board stacking, thereby reducing the flexibility in application of the packaged products.

Furthermore, under the trend for high-functionality and high-speed electronic products, passive components such as resistors, capacitors, and inductors are required to be integrated into the semiconductor package to increase or stabilize the electrical functionalities of the electronic products. However, these passive components are usually mounted on the surface of the circuit board, conventionally on the corners of the circuit board or additional layout areas outside the semiconductor connecting region of the circuit board to prevent blocking the electrical connection of bonding fingers between the semiconductor chip and the circuit board. However, limiting the passive components reduces the routability of wires on the surface of the circuit board. The number of the passive components is also limited concerning locations of the bonding fingers. Following the demands for high functionality of the semiconductor package, the number of passive components is increased accordingly, which will forcibly increase the package size to accommodate for large numbers of semiconductor chips and passive components.

Document EP 1 139 705 A1 discloses in figures 1-7 a semiconductor package structure which comprises a carrying structure with supporting boards 30a, 30c wherein the carrying structure is manufactured by a hot-pressing step in order to fix the electronic components within the carrying structure. The electronic components are mounted on one of the supporting boards before the hot-pressing step.

### SUMMARY OF THE INVENTION

In the light of forgoing drawbacks, an objective of the present invention is to provide a carrying structure of electronic components to effectively mount the electronic component in the carrying structure.

Another objective of the present invention is to provide a carrying structure of electronic components for mounting different electronic components therein to provide better electrical functionalities.

In accordance with the above and other objectives, the present invention provides a structure comprising a carrying structure of electronic components and a circuit build-up structure. The carrying structure comprises a first supporting board and a second supporting board, each of the first and second supporting boards having at least one hole extending through the corresponding supporting board; an adhesive layer formed between the first and second supporting boards and at least one electronic component including an active face with a plurality of electrode pads and a non-active face, each electronic component being disposed in a respective hole of the first supporting board and in a respective hole of the second supporting board; wherein a portion of the adhesive layer fills a gap between each electronic component
and the first and second supporting boards, so as to fix each electronic component in the holes of the first and second supporting boards; and wherein the circuit build-up structure is formed on the carrying structure and on the active face of the electronic component, and wherein the circuit build-up structure comprises a plurality of conductive structures formed in the circuit build-up structure and electrically connected to the plurality of electrode pads of the electronic component, and connecting pads are formed on a surface of the circuit build-up structure.

In one embodiment of the present invention, the adhesive layer forming on the surface of the supporting board is one selected from the group consisting of an organic film dielectric material, liquid organic resin material and Prepreg. Said materials can be photosensitive or non-photosenstive organic resin selected from the group consisting of ABF(Ajinomoto Build-up Film), PPE(Poly(phenylene ether)), PTFE(Poly(tetra-fluoroethylene)), FR4, FR5, BT(Bismaleimide Triazine), LCP(Liquid Crystal Polymer), BCB(Benzocyclo-buthene), PI(Poly-imide) and Aramide. In one embodiment, the supporting board can be made of a metal material, a ceramic material, a circuit board having wiring structures or other dielectric materials. The metal material is preferably one selected from the group consisting of copper, aluminum, nickel, iron, titanium and magnesium or an alloy material thereof. Additionally, the supporting board may be a circuit board with wiring structure. The electronic component can be a passive component, an active component, an optoelectronics element, a semiconductor chip or other suitable element.

Moreover, the active face of the electronic component can be selectively flushed with or protruding out of the top of the carrying structure, and the non-active face of the electronic component can be selectively flushed with or protruding out of the bottom of the carrying structure.

It can be understood that the above construction allows the active face of the electronic component to be exposed from the cavity of the carrying structure for directly forming subsequent wiring layer structure thereon. Thereby, the complicated fabrication processes and high cost due to conventional approach of using electrical connecting units for connecting the semiconductor chip to the circuit board can be eliminated. Moreover, the reliability of the fabrication processes can be improved.

Meanwhile, the electronic component is adhered to the carrying structure via pressing the adhesive layer. The present invention thus requires no additional injection of adhesive layer to fill the cavity of the supporting board. This reduces the size of package since the semiconductor chip is no longer required to be adhered on direct top of the circuit board and encapsulated with encapsulation material. Furthermore, the electronic component can be secured firmly in the carrying structure. Several different electronic components can be disposed simultaneously in the carrying structure, providing better electrical functionalities, improved flexibility in application of the package products, reduced routing, and improved quality and reliability of the semiconductor packages.

### BRIEF DESCRIPTION OF THE DRAWINGS

The present invention can be more fully understood by reading the following detailed description of the preferred embodiments, with reference made to the accompanying drawings, wherein:

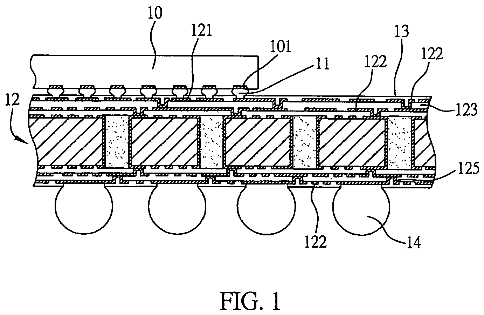

Fig. 1 shows a sectional schematic diagram of a conventional flip chip semiconductor package;
Figs. 2A to 2C are schematic diagrams showing a carrying structure of electronic components according to a first embodiment not forming part of the invention;
Figs. 3A to 3C are schematic diagrams showing a carrying structure of electronic components according to a second embodiment. Figs. 3A and 3C refer to embodiments not forming part of the invention whereas Fig. 3B refers to an embodiment of the present invention;
Figs. 4A to 4C are schematic diagrams showing a carrying structure of electronic components according to a third embodiment not forming part of the invention; and
Figs. 5A to 5C are schematic diagrams showing a carrying structure of electronic components according to a fourth embodiment which is an embodiment of the present invention.

### DETAILED DESCRIPTION OF THE EMBODIMENTS

Specific first and third embodiments not forming part of the invention, a specific second embodiment, and a specific fourth embodiment which embodies the present invention will now be described in detail with reference to the drawings, however, it should be noted that the
structures and shapes illustrated in the description and drawings are for illustration only rather than limiting the present invention.

### [First Embodiment]

The carrying structure of electronic components comprises a supporting board with at least one cavity; at least one electronic component having an active face and a non-active face provided in the corresponding cavity of the supporting board; and at least one adhesive layer formed on a surface of the supporting board, wherein the adhesive layer partly fills a gap between the cavity and the electronic component, such that the electronic component is fixed in the cavity of the supporting board.

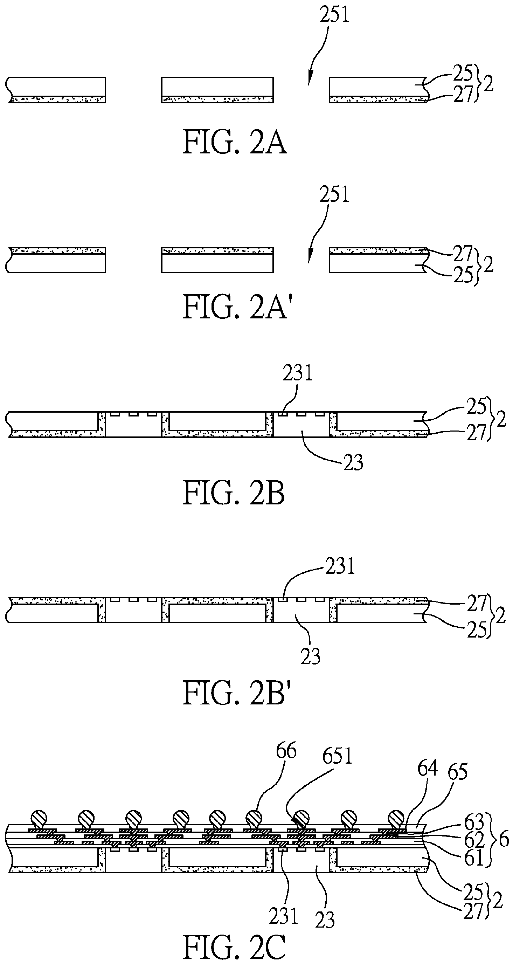

Referring now to Figs. 2A and 2B showing schematic diagrams of the carrying structure of electronic components not forming part of the present invention. The carrying structure 2
comprises a supporting board 25 having at least one cavity 251, wherein an adhesive layer 27 is formed on a surface of the supporting board 25. In this embodiment, the carrying structure 2 may be for example a double-layered structure comprising the supporting board 25 and the adhesive layer 27 formed on the surface of the supporting board 25; wherein the adhesive layer 27 can be one selected from the group consisting of an organic film dielectric material, liquid organic resin material and Prepreg. Said materials can be photosensitive or non-photosenstive organic resin selected from the group consisting of ABF(Ajinomoto Build-up Film), PPE(Poly(phenylene ether)), PTFE(Poly(tetra-fluoroethylene)), FR4, FR5, BT(Bismaleimide Triazine), LCP(Liquid Crystal Polymer), BCB(Benzocyclo-buthene), PI(Poly-imide) and Aramide. The supporting board 25 can be made of a metal material, a ceramic material, a circuit board having wiring structures or other dielectric materials. The metal material is preferably one selected from the group consisting of copper, aluminum, nickel, iron, titanium and magnesium or an alloy material thereof. The cavity 251 of the supporting board 25 is provided with at least one electronic component 23, and a plurality of electrode pads 231 are formed on an active face of the electronic component 23. When the electronic component 23 is placed in the cavity 251 of the supporting board, the carrying structure 2 is heated and pressed, such that a portion of the adhesive layer 27 on the surface of the supporting board 25 fills a gap between the cavity 251 and the electronic component 23 to fix the electronic component 23 in the cavity 251 of the supporting board. The electronic component can be a passive component, an active component, an optoelectronics element, a semiconductor chip or other suitable element. The electronic component may comprise electrode pads 231 made of metal.

Accordingly, the electronic component can be effectively secured in the carrying structure. Alternatively, a plurality of electronic components can be embedded so that several different electronic components can be mounted in the carrying structure simultaneously.

Referring now to Fig. 2C, Circuit build-up process is performed. A circuit build-up structure 6 is formed on one side or both sides of the carrying structure 2 receiving the electronic component 23. The circuit build-up structure 6 comprises a dielectric layer 61, a wiring layer 62 stacked on the dielectric layer 61, and a conductive structure 63 formed on the dielectric layer 61. The conductive structure 63 electrically connected to the electrode pads 231 of the electronic component 23. A plurality of connecting pads 64 are formed on a surface of the circuit build-up structure 6, and a solder mask 65 is formed on the outermost surface of the circuit build-up structure 6. The surface of the solder mask 65 has a plurality of openings 651 for exposing the connecting pads 64 of the circuit build-up structure 6, and conductive elements 66 (such as solder ball) connected to the connecting pads 64 are formed in the opening 651 of the solder mask 65. The conductive elements 66 can also be made of pin-shaped metals or other conductive adhesive materials.

Referring to Figs. 2A' and 2B' showing an alternative implementation aspect of this embodiment. This alternative implementation differs from the previous embodiment in that the adhesive layer 27 is positioned in a surface of the supporting board 25 opposite to the surface of the supporting board 25 with the adhesive layer in the previous embodiment. The electronic component 23 is placed in the cavity 251 of the supporting board, and the carrying structure 2 is hot pressed, such that a portion of the adhesive layer 27 on the surface of the supporting board 25 fills a gap between the cavity 251 and the electronic component 23 to fix the electronic component 23 in the cavity 251 of the supporting board 25.

### [Second Embodiment]

The carrying structure of electronic components of this embodiment comprises at least a first supporting board and a second supporting board having at least one cavity, respectively; at least one adhesive layer formed between the first and the second supporting boards; and at least one electronic component comprising an active and non-active face provided in the corresponding cavities of the first and second supporting boards, wherein a portion of the adhesive layer fills a gap between the electronic element and the cavities of the first and second supporting boards, thereby mounting the electronic component in the cavities of the first and second supporting boards.

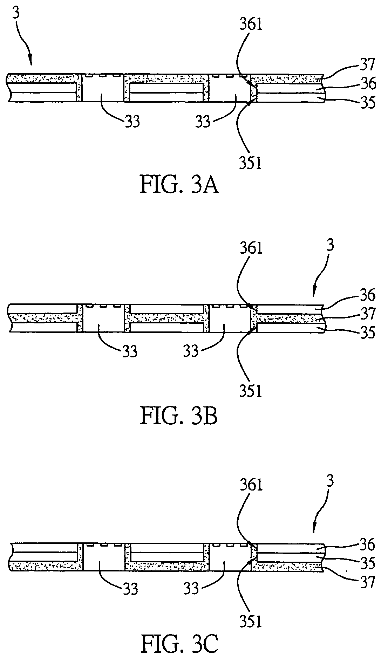

Referring to Figs. 3A to 3C, schematic diagrams of a carrying structure 3 for electronic components according to the embodiment are
shown. The second embodiment essentially differs from the first embodiment in that the carry structure 3 is a multi-layered structure with at least one electronic component, an adhesive layer made of organic resin and at least two supporting boards. In an aspect of this embodiment not forming part of the invention (as shown in Fig. 3A), the carrying structure 3 can be for example a three-layered structure comprising a first supporting board 35, a second supporting board 36 and an adhesive layer 37. The adhesive layer can be made of organic resin materials. The first and second supporting boards 35, 36 can be made of metal materials, ceramic materials, circuit boards with wiring structure or other dielectric materials. The second supporting board 36 is stacked on the surface of the first supporting board 35, where the adhesive layer 37 is formed on a surface of the second supporting board 36 without the first supporting board 35. The first and second supporting boards 35 and 36 respectively have cavities 351 and 361 for receiving the electronic component 33.

In another aspect of this embodiment as shown in Fig. 3B which is an embodiment of the present invention, the carrying structure 3 comprises an adhesive layer 37 disposed between first and second supporting boards 35 and 36. The first and second supporting boards 35 and 36 respectively have cavities 351 and 361 for receiving the electronic component 33.

In yet another aspect of this embodiment not forming part of the present invention as shown in Fig. 3C, the carrying
structure 3 comprises a first supporting board 35 and a second supporting board 36 stacked on the first supporting board 35, and an adhesive layer formed on a surface of the first supporting board 35 not connected to the second supporting board 36. The first and second supporting boards 35 and 36 respectively have cavities 351 and 361 for receiving the electronic component 33.

In the above three-layered embodiments, the carrying structure 3 is hot pressed, so that the adhesive layer 37 between the first and second supporting boards or on a surface of one of the first or second supporting board partially fills a gap between the electronic component 33 and the cavities 351 and 361 to secure the electronic component 33 firmly in the cavities 351 and 361 of the first and second supporting boards 35 and 36.

From the above, it can be understood that in the previous embodiments, the carrying structure may be a multi-layered structure with an organic resin adhesive layer, wherein the adhesive layer is hot pressed to firmly mount the electronic component in the supporting board(s) made of materials such as metal, ceramic, circuit board(s) with wiring structure or other dielectric materials, without the need for additionally injected adhesive material.

### [Third Embodiment]

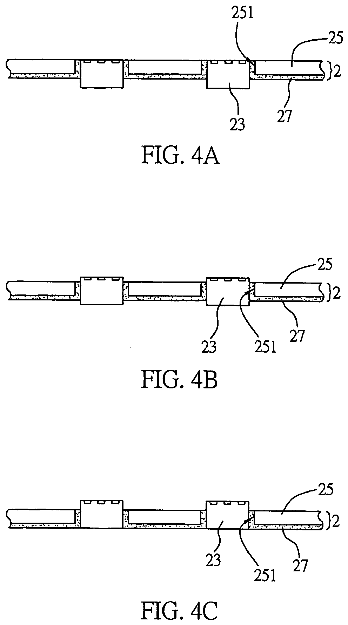

Referring to Figs. 4A to 4C, schematic diagrams of a carrying structure of electronic components according to still another embodiment not forming part of the present invention
are shown, wherein like elements are designated with like reference numerals and will not be described in detail.

As shown in Fig. 4A, the carrying structure comprises a supporting board 25, at least one electronic component 23 and an adhesive layer 27 formed on a surface of the supporting board 25.

The supporting board 25 has at least one cavity 251. Although the carrying structure 2 is shown as a two-layered structure comprising the supporting board 25 and the adhesive layer 27, it is not limited to this.

The electronic component 23 has an active face and a non-active face, where the active face is on the top surface and the non-active face is on bottom surface. The electronic component 23 is disposed in the cavity of the supporting board 25. The electronic component 23 can be a passive component, an active component, an optoelectronics component, a semiconductor chip or other suitable components. In this embodiment, the active face of the electronic component 23 is flush with the top of the carrying structure 2, and the non-active face of the electronic component 23 protrudes out of the bottom of the carrying structure 2.

The adhesive layer 27 partially fills a gap between the cavity 251 and the electronic component 23, so as to fix the electronic component 23 in the cavity 251 of the supporting board 25. The adhesive layer 27 filling in the cavity 251 is achieved by hot pressing the adhesive layer 27 on the surface of the supporting board 25.

This method can also be applied to placing the electronic component 33 of the second embodiment in the carrying structure of Figs 3A to 3C, such that the active face of the electronic component 3 is flushed with the top of the carrying structure 3; or the non-active face is flushed with the bottom of the carrying structure 3; or the active face of the electronic component 3 protrudes out of the top of the carrying structure 3; or the non-active face protrudes out of the bottom of the carrying structure 3.

With such construction, the structure of the carrying structure of electronic components can be simplified, while the electronic component can be securely fixed in the carrying structure, and a better electrical functionality is provided. Thus, the present invention successfully solves the problems in the prior art.

### [Fourth Embodiment]

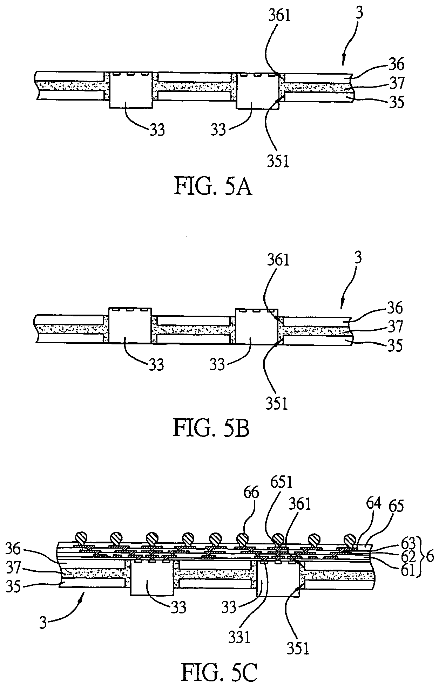

Referring to Fig. 5A, a schematic diagram of a carrying structure according to an embodiment of the present invention is shown. The carrying structure 3 is a three-layered structure comprising first and second supporting boards 35 and 36 and an adhesive layer 37 disposed therebetween. The first and second supporting boards 35 and 36 have respective cavities 351 and 361 for receiving an electronic component 33. In this three-layered embodiment, the carrying structure 3 is hot pressed such that the adhesive layer 37 between the first and second supporting boards 35 and 36 partially fills a gap between the electronic component 33 and the cavities 351 and 361, mounting the electronic component 33 in the cavities 351 and 361 of the first and second supporting boards 35 and 36. The non-active face of the electronic component protrudes out of the bottom of the carrying structure 3. Alternatively, the carrying structure 3 is a three-layered structure comprising first and second supporting boards 35 and 36 and an adhesive layer 37 disposed therebetween. The first and second supporting boards 35 and 36 have respective cavities 351 and 361 for receiving an electronic component 33, and wherein the active face of the electronic component 33 protrudes out of the top of the carrying structure 3, as shown in Fig. 5B.

Referring to 5C, subsequent layering process can be performed. A circuit build-up structure 6 is formed on the carrying structure receiving the electronic component 33. The circuit build-up structure 6 can also be implemented on one side or both sides of the carrying structure 2. The circuit build-up structure 6 is already described in previous embodiments and thus will not be described again.

Other advantages and effects will be readily appreciated by those skilled in the art via the detailed description disclosed in this specification. The present invention can be practiced by other embodiments, and should therefore cover various modifications and variations made to the herein-described details of the present invention, provided they fall within the scope of the present invention as defined in the following appended claims.

## Claims

1. A structure comprising a carrying structure of electronic components and a circuit build-up structure,
wherein the carrying structure (3) comprises:
a first supporting board (35) and a second supporting board (36), each of the first and
second supporting boards having at least one hole (351, 361) extending through the
corresponding supporting board;
an adhesive layer (37) formed between the first and second supporting boards (35, 36); and
at least one electronic component (33) including an active face with a plurality of
electrode pads and a non-active face, each electronic component (33) being disposed
in a respective hole (351) of the first supporting board (35) and in a respective hole (361) of the
second supporting board (36);
wherein a portion of the adhesive layer (37) fills a gap between each electronic
component (33) and the first and second supporting boards (35, 36), so as to fix each electronic
component (33) in the holes (351, 361) of the first and second supporting boards (35, 36); and
wherein the circuit build-up structure (6) is formed on the carrying structure (3) and on
the active face of each electronic component (33), and wherein the circuit build-up structure (6) comprises a plurality of conductive structures formed in the circuit build-up structure
and electrically connected to the plurality of electrode pads of the electronic component (33), and connecting pads (64) are formed on a surface of the circuit build-up structure (6).

2. The structure of claim 1, wherein the adhesive layer (37) is made from one of an organic
dielectric material, a liquid organic resin material and a Prepreg.

3. The structure of claim 1, wherein each electronic component (33) is one selected from the
group consisting of a passive component, an active component, an optoelectronics element, and a semiconductor chip.

4. The structure of claim 1, wherein the active face of each electronic component (33) is
flushed with a top surface of the carrying structure (3).

5. The structure of claim 1, wherein the active face of each electronic component (33) protrudes out of a top surface of the carrying structure (3).

6. The structure of claim 1, wherein the non-active face of each electronic component (33) is
flushed with a bottom surface of the carrying structure (3).

7. The structure of claim 1, wherein the non-active face of each electronic
component (33) protrudes out of a bottom surface of the carrying structure (3).

8. The structure of claim 1, further comprising a solder mask (65) formed on the surface of
the circuit build-up structure (6), and having a plurality of openings (651) for exposing the connecting pads (64) of the circuit build-up structure (6).

## Patentansprüche

1. Struktur, umfassend eine Trägerstruktur für elektronische Komponenten und eine Schaltungsaufbaustruktur,
wobei die Trägerstruktur (3) umfasst:
eine erste Stützplatte (35) und eine zweite Stützplatte (36), die jeweils mindestens ein Loch (351, 361) aufweisen, das durch die jeweilige Stützplatte verläuft;
eine Klebemittelschicht (37), die zwischen der ersten und zweiten Stützplatte (35, 36) ausgebildet ist, und
wenigstens eine elektronische Komponente (33), einschließlich einer aktiven Fläche mit einer Vielzahl von Elektrodenflecken und einer nicht-aktiven Fläche, wobei jede elektronische Komponente (33) in einem entsprechenden Loch (351) der ersten Stützplatte (35) und in einem entsprechenden Loch (361) der zweiten Stützplatte (36) angeordnet ist;
wobei ein Abschnitt der Klebemittelschicht (37) einen Spalt zwischen jeder elektronischen Komponente (33) und der ersten und zweiten Stützplatte (35, 36) ausfüllt, um jede elektronische Komponente (33) in den Löchern (351, 361) der ersten und zweiten Stützplatte (35, 36) zu befestigen;
und wobei die Schaltungsaufbaustruktur (6) auf der Trägerstruktur (3) und auf der aktiven Fläche jeder elektronischen Komponente (33) ausgebildet ist, und wobei die Schaltungsaufbaustruktur (6) eine Vielzahl von Leiterstrukturen umfasst, die in der Schaltungsaufbaustruktur ausgebildet und elektrisch mit der Vielzahl von Elektrodenflecken der elektronischen Komponente (33) verbunden sind, und Anschlusspunkte (64) auf einer Oberfläche der Schaltungsaufbaustruktur (6) ausgebildet sind.

2. Struktur nach Anspruch 1, wobei die Klebemittelschicht (37) aus einem organischen, dielektrischen Material, einem flüssigen organischen Harzmaterial und einem Prepreg hergestellt ist.

3. Struktur nach Anspruch 1, wobei jede elektronische Komponente (33) ausgewählt ist aus der Gruppe, bestehend aus einer passiven Komponente, einer aktiven Komponente, einem optoelektronischen Element und einem Halbleiter-Chip.

4. Struktur nach Anspruch 1, wobei die aktive Fläche jeder elektronischen Komponente (33) bündig zu einer Oberseite der Trägerstruktur (3) angeordnet ist.

5. Struktur nach Anspruch 1, wobei die aktive Fläche jeder elektronischen Komponente (33) aus einer Oberseite der Trägerstruktur (3) hervorsteht.

6. Struktur nach Anspruch 1, wobei die nicht-aktive Fläche jeder elektronischen Komponente (33) bündig zu einer Unterseite der Trägerstruktur (3) angeordnet ist.

7. Struktur nach Anspruch 1, wobei die nicht-aktive Fläche jeder elektronischen Komponente (33) von einer Unterseite der Trägerstruktur (3) hervorsteht.

8. Struktur nach Anspruch 1, ferner umfassend eine Lötmaske (65), die auf der Oberfläche der Schaltungsaufbaustruktur (6) ausgebildet ist und eine Vielzahl von Öffnungen (651) zum Belichten der Anschlusspunkte (64) der Schaltungsaufbaustruktur (6) aufweist.

## Revendications

1. Structure comprenant une structure porteuse de composants électroniques et une structure de constitution de circuit,
dans laquelle la structure porteuse (3) comprend :
une première carte de support (35) et une seconde carte de support (36), chacune des première et seconde cartes de support comportant au moins un trou (351, 361) s'étendant à travers la carte de support correspondante ;
une couche adhésive (37) formée entre les première et seconde cartes de support (35, 36) ; et
au moins un composant électronique (33) comprenant une face active dotée d'une pluralité de plots de connexion d'électrode et une face non active, chaque composant électronique (33) étant disposé dans un trou respectif (351) de la première carte de support (35) et dans un trou respectif (361) de la seconde carte de support (36) ;
dans laquelle une partie de la couche adhésive (37) remplit un espace séparant chaque composant électronique (33) et les première et seconde cartes de support (35, 36), de façon à fixer chaque composant électronique (33) dans les trous (351, 361) des première et seconde cartes de support (35, 36) ; et
dans laquelle la structure de constitution de circuit (6) est formée sur la structure porteuse (3) et sur la face active de chaque composant électronique (33), et dans laquelle la structure de constitution de circuit (6) comprend une pluralité de structures conductrices formées dans la structure de constitution de circuit et connectées électriquement à la pluralité de plots de connexion d'électrode du composant électronique (33), et des plots de connexion (64) sont formés sur une surface de la structure de constitution de circuit (6).

2. Structure selon la revendication 1, dans laquelle la couche adhésive (37) est réalisée à partir de l'un d'un matériau diélectrique organique, d'un matériau de résine organique liquide et d'un pré-imprégné.

3. Structure selon la revendication 1, dans laquelle chaque composant électronique (33) est un composant choisi à partir du groupe constitué d'un composant passif, d'un composant actif, d'un élément optoélectronique et d'une puce à semi-conducteur.

4. Structure selon la revendication 1, dans laquelle la face active de chaque composant électronique (33) est à fleur d'une surface supérieure de la structure porteuse (3).

5. Structure selon la revendication 1, dans laquelle la face active de chaque composant électronique (33) fait saillie d'une surface supérieure de la structure porteuse (3).

6. Structure selon la revendication 1, dans laquelle la face non active de chaque composant électronique (33) est à fleur d'une surface inférieure de la structure porteuse (3).

7. Structure selon la revendication 1, dans laquelle la face non active de chaque composant électronique (33) fait saillie d'une surface inférieure de la structure porteuse (3).

8. Structure selon la revendication 1, comprenant en outre un masque de soudure (65) formé sur la surface de la structure de constitution de circuit (6), et comportant une pluralité d'ouvertures (651) servant à exposer les plots de connexion (64) de la structure de constitution de circuit (6).
